(19) Europäisches Patentamt

European Patent Office

Office européen des brevets

(11) **EP 0 782 257 B1**

(12) **FASCICULE DE BREVET EUROPEEN**

(45) Date de publication et mention
de la délivrance du brevet:
**07.03.2001 Bulletin 2001/10**

(51) Int Cl.⁷: **H03H 11/30**, H03F 1/32,
H04M 19/04

(21) Numéro de dépôt: **96410121.6**

(22) Date de dépôt: **17.12.1996**

(54) **Dispositif adaptatif à l'impédance d'une ligne d'alimentation**

Schaltung zur Anpassung an die Impedanz einer Spannungsversorgungsleitung

Impedance matching device for supply line

(84) Etats contractants désignés:
**DE FR GB IT**

(30) Priorité: **27.12.1995 FR 9515830**

(43) Date de publication de la demande:
**02.07.1997 Bulletin 1997/27**

(73) Titulaire: **STMicroelectronics S.A.**
**94250 Gentilly (FR)**

(72) Inventeur: **Renous, Claude**
**38100 Grenoble (FR)**

(74) Mandataire: **de Beaumont, Michel**
**1bis, rue Champollion**
**38000 Grenoble (FR)**

(56) Documents cités:
**EP-A- 0 415 503          EP-A- 0 554 192**
**DE-A- 3 744 112          US-A- 4 631 491**

# Description

La présente invention concerne un dispositif qui adapte automatiquement son impédance à l'impédance d'une ligne d'alimentation afin de disposer d'une puissance maximale. La présente invention s'applique plus particulièrement à l'alimentation du haut-parleur d'un poste téléphonique pendant une sonnerie afin de délivrer un signal acoustique le plus fort possible.

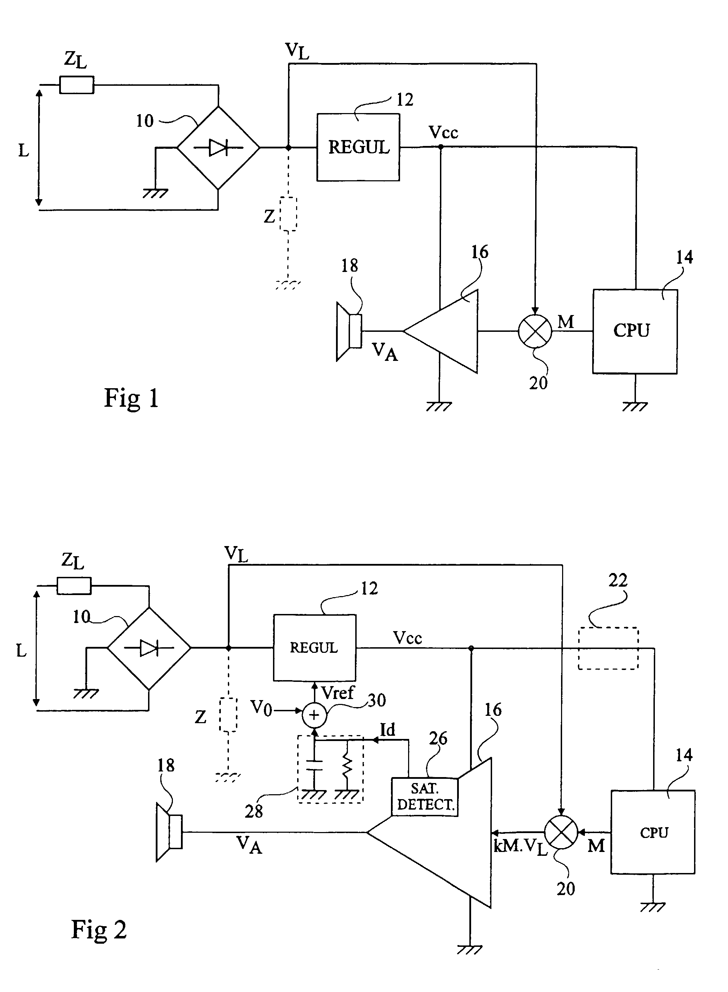

La figure 1 représente schématiquement un circuit de sonnerie classique permettant une adaptation automatique à l'impédance d'une ligne téléphonique L. Il comprend un pont redresseur 10 délivrant la tension de ligne redressée $V_L$ à un régulateur 12. Ce régulateur fournit une tension régulée constante Vcc qui alimente notamment un microprocesseur 14 et un amplificateur de sonnerie 16 relié au haut-parleur 18.

Lors d'une sonnerie, le microprocesseur 14 délivre une mélodie M, sous forme de signal rectangulaire de fréquence variable, à transmettre au haut-parleur 18.

Une ligne téléphonique présente une impédance $Z_L$ non-négligeable et qui varie de manière indéterminée d'une installation à l'autre. La puissance prélevée sur la ligne L est maximale lorsque l'impédance Z présentée par le ou les circuits reliés à la ligne est égale à l'impédance $Z_L$.

Le circuit de la figure 1 comprend une boucle de régulation formée par un multiplieur 20 qui applique le produit du signal M par la tension de ligne $V_L$ à l'entrée de l'amplificateur 16. Le gain de l'amplificateur 16 ou du multiplieur 20 est choisi de manière que l'amplitude du signal $V_A$ appliqué au haut-parleur 18 se stabilise à une valeur pour laquelle l'impédance Z du circuit est voisine de l'impédance $Z_L$ de la ligne L.

Ainsi, l'amplitude du signal $V_A$ de sortie de l'amplificateur 16 est la plupart du temps inférieure à la tension Vcc d'alimentation de l'amplificateur. Ceci provoque une perte de puissance qui est dissipée dans l'amplificateur 16 et non fournie au haut-parleur 18.

La demande de brevet européen 0 554 192 décrit un circuit de sonnerie similaire permettant de supprimer la puissance perdue dans l'amplificateur, et donc de fournir davantage de puissance au haut-parleur. Pour cela, le multiplieur 20 est remplacé par un modulateur de largeur d'impulsion qui règle le rapport cyclique du signal de sonnerie en fonction de la tension de ligne.

Toutefois, lorsque la puissance disponible est particulièrement faible, par exemple quand plusieurs postes sont reliés en parallèle sur la même ligne, le signal transmis au haut-parleur est constitué d'impulsions étroites qui ont un grand nombre d'harmoniques désagréables à l'écoute.

Un objet de la présente invention est de prévoir un circuit de sonnerie agréable à l'écoute, adaptatif à l'impédance de la ligne, et alimentant de manière optimale le haut-parleur.

Un objet plus général de la présente invention est de prévoir un dispositif adaptatif à l'impédance d'une ligne d'alimentation et qui alimente de manière optimale une charge par un signal quelconque prélevé sur la ligne.

Ces objets sont atteints grâce à un dispositif adaptatif à l'impédance d'une ligne d'alimentation pour alimenter une charge de manière optimale, comprenant un régulateur de tension à découpage sur lequel est prélevé un signal fourni à la charge, une boucle de régulation pour régler l'amplitude du signal fourni à la charge en fonction de la tension sur la ligne, et des moyens d'alignement de la tension de sortie du régulateur de tension sur l'amplitude du signal fourni à la charge.

Selon un mode de réalisation de la présente invention, les moyens d'alignement comprennent un moyen de comparaison fournissant un signal de détection actif lorsque la tension de sortie du régulateur de tension est inférieure à l'amplitude réglée du signal à fournir à la charge, et un filtre passe-bas recevant le signal de détection et modifiant une tension de référence du régulateur de tension.

Selon un mode de réalisation de la présente invention, le régulateur de tension reçoit une tension de référence basse à laquelle est ajoutée la tension de sortie du filtre passe-bas.

Selon un mode de réalisation de la présente invention, le dispositif comprend un amplificateur alimentant la charge et recevant le produit d'un signal de consigne par la tension sur la ligne, le moyen de comparaison étant formé d'un détecteur de saturation de l'amplificateur.

Selon un mode de réalisation de la présente invention, l'amplificateur comprend un transistor de sortie alimentant la charge à partir de la tension de sortie du régulateur de tension, le détecteur de saturation étant prévu pour détecter la saturation du transistor de sortie.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

la figure 1, précédemment décrite, est destinée à illustrer l'état de la technique et un problème à résoudre par la présente invention ;

la figure 2 représente un mode de réalisation de dispositif selon l'invention d'adaptation à l'impédance d'une ligne d'alimentation ;

la figure 3 représente schématiquement des allures de signaux pour illustrer le fonctionnement du circuit de la figure 2 ; et

la figure 4 représente un exemple de détecteur de saturation utilisé dans le circuit de la figure 2.

Dans la figure 2, des mêmes éléments qu'à la figure 1 sont désignés par des mêmes références. Comme dans la figure 1, un circuit de sonnerie selon l'invention agit sur l'amplitude du signal $V_A$ fourni par l'amplificateur 16 de manière à adapter l'impédance Z du circuit à l'impédance $Z_L$ de la ligne téléphonique L.

Selon un aspect essentiel de l'invention, afin de minimiser les pertes de puissance dans l'amplificateur 16, la tension de sortie Vcc du régulateur 12 est alignée sur l'amplitude du signal $V_A$. Bien entendu, pour que l'on puisse modifier la tension de sortie Vcc du régulateur 12 sans pertes de puissance, le régulateur 12 est nécessairement un régulateur à découpage, ce qui est généralement le cas.

La plage de variation de la tension Vcc doit être telle que le microprocesseur 14 et l'amplificateur 16 puissent fonctionner convenablement. Ainsi, la tension Vcc a une limite inférieure (souvent 3 V) en dessous de laquelle l'amplificateur 16 et le microprocesseur 14 ne fonctionnent pas et une limite supérieure où le microprocesseur 14 consomme trop de courant. Il est avantageux de disposer entre le régulateur 12 et le microprocesseur 14 un régulateur supplémentaire 22 qui alimente le microprocesseur 14 à une tension constante égale à la limite inférieure (3 V) de la tension Vcc. Le régulateur 22 n'a pas besoin d'avoir un bon rendement et peut donc être de structure simple (régulateur série).

Afin d'aligner la tension Vcc de sortie du régulateur 12 sur l'amplitude de la tension $V_A$ fournie au haut-parleur 18, on détecte l'écart entre la tension Vcc et l'amplitude de la tension $V_A$ et on modifie en fonction de cet écart une tension de référence Vref du régulateur 12 de manière à réduire cet écart.

La figure 2 représente un mode de réalisation particulièrement simple pour obtenir cette fonction. L'amplificateur 16 est muni d'un détecteur de saturation 26 qui fournit un signal Id actif lorsque l'amplificateur 16 entre en saturation, c'est-à-dire lorsque la tension d'alimentation Vcc est trop basse pour que l'amplificateur 16 puisse fournir un signal $V_A$ d'amplitude correspondant à son signal d'entrée $kM·V_L$ (le coefficient k est le gain du multiplieur 20 ou un coefficient multiplicateur appliqué à l'un ou l'autre des signaux M et $V_L$). Le signal de détection Id subit un filtrage passe-bas en 28 avant d'être ajouté en 30 à une tension de référence basse $V_0$ pour constituer la tension de référence Vref du régulateur 12. La tension de référence basse $V_0$ correspond à la limite inférieure de la tension Vcc. Le signal Id est généralement un courant ; le filtre passe-bas 28 comprend alors une capacité et une résistance reliées en parallèle à un potentiel fixe, par exemple la masse.

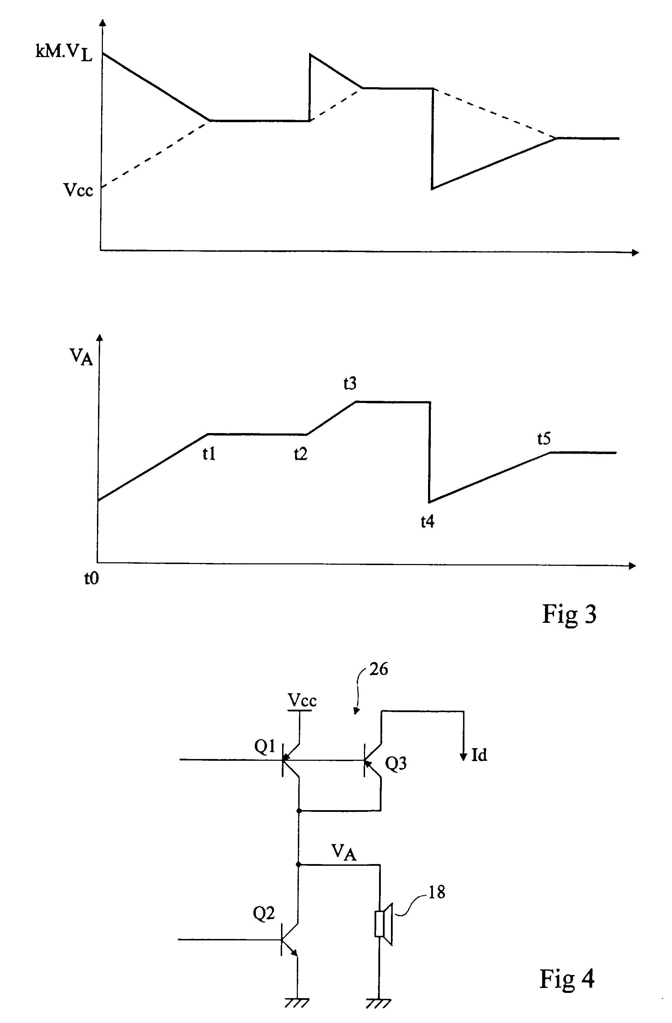

La figure 3 illustre un exemple de variation de la tension d'entrée $kM·V_L$ de l'amplificateur 16, de la tension de sortie Vcc du régulateur 12, et de la tension $V_A$ fournie au haut-parleur 18. On suppose que l'amplificateur 16 est de gain unitaire et donc que l'amplitude du signal $V_A$ est normalement égale à celle du signal $kM·V_L$. Bien que le signal M soit normalement rectangulaire dans un circuit de sonnerie, on suppose ici qu'il est continu et égal à 1, ce qui simplifie la compréhension et montre que le dispositif selon l'invention peut être utilisé pour alimenter de manière optimale une charge (18) avec un signal quelconque.

Initialement, à un instant t0, la tension Vcc est à sa limite inférieure, déterminée par la tension de référence basse $V_0$. Le signal M passe d'une valeur nulle à sa valeur nominale (constante). L'impédance Z du circuit est initialement élevée, puisque le circuit ne consommait pratiquement aucun courant jusqu'à l'instant t0. Ainsi, la tension de ligne $V_L$, et donc le produit $kM·V_L$ sont élevés, tellement que l'amplificateur 16 sature (l'amplitude du signal $V_A$ et égale à la tension Vcc). Le détecteur de saturation 26 fournit un courant Id qui charge la capacité du filtre 28, d'où il résulte que la tension de référence Vref, et donc la tension Vcc, augmentent. La tension $V_A$ suit cette évolution puisque le produit $kM·V_L$ est toujours trop élevé. Par conséquent, l'impédance Z du circuit diminue puisque l'amplificateur 16 fournit un courant croissant au haut-parleur 18. Ainsi, la tension $V_L$ se met à diminuer et finit à un instant t1 par atteindre une valeur où l'amplitude de la tension $V_A$ est égale au produit $kM·VL$.

A l'instant t1, on atteint une situation d'équilibre où l'amplificateur 16 est à la limite de la saturation et où le détecteur de saturation 26 fournit un courant Id juste suffisant pour maintenir constante la tension aux bornes de la capacité du filtre 28, et donc maintenir constante la tension Vcc.

L'état d'équilibre de l'instant t1 doit correspondre au réglage optimal. Pour cela, le coefficient k est choisi de manière que la tension de ligne $V_L$ soit, à l'équilibre, égale à la moitié de la tension nominale en amont de la ligne L (ce qui revient à dire que l'impédance Z du circuit est égale à l'impédance de liane $Z_L$). Le coefficient k optimal est exprimé par :

$$k = \sqrt{\frac{\rho \cdot R_{HP}}{Z_L}} \qquad (1)$$

où $R_{HP}$ est la résistance du haut-parleur 18 et $\rho$ le rendement global du régulateur 12 et de l'amplificateur 16.

A un instant t2, la puissance disponible sur la ligne L augmente brusquement, par exemple à la suite du débranchement d'un poste téléphonique. Cette augmentation de puissance se traduit par une augmentation de la tension de ligne $V_L$, et donc du produit $kM·V_L$. La tension Vcc ne suivant pas immédiatement cette évolution, l'amplificateur 16 ne peut plus délivrer un signal $V_A$ avec une amplitude correspondant au produit $kM·V_L$. Il sature et la tension Vcc augmente tandis que la tension $V_L$ diminue.

A un instant t3, l'amplificateur 16 est de nouveau à la limite de la saturation. La tension Vcc se stabilise alors à une valeur supérieure à celle atteinte à l'instant t1, puisqu'une puissance supérieure est disponible.

A un instant t4, la puissance disponible chute brutalement, par exemple parce que l'on a connecté un ou plusieurs postes téléphoniques sur la ligne. La tension $V_L$ chute tellement que le produit $kM \cdot V_L$ devient inférieur à la tension Vcc. L'amplificateur 16 fournit donc le signal $V_A$ correspondant sans saturer. Le détecteur de saturation 26 reste inactif, la capacité du filtre 28 se décharge, et la tension Vcc diminue. La tension Vcc se rapproche donc de l'amplitude du signal $V_A$, ce qui réduit la puissance perdue dans l'amplificateur 16. La puissance perdue dans l'amplificateur 16 diminuant, l'impédance Z du circuit, et donc la tension de ligne $V_L$, augmentent. En conséquence, le produit $kM \cdot V_L$ et l'amplitude du signal $V_A$ augmentent.

A un instant t5, l'amplitude du signal $V_A$ et la tension Vcc sont telles que l'amplificateur 16 est à la limite de la saturation, ce qui correspond de nouveau à un état d'équilibre optimal.

Bien que la description qui précède est basée sur l'exemple d'un signal M continu, il est clair que ce signal M peut être quelconque, notamment alternatif (rectangulaire ou autre) pour produire une mélodie. Les évolutions représentées à la figure 3 pour les signaux continus constituent alors les enveloppes des signaux correspondants alternatifs.

L'expression (1) ci-dessus fournit le coefficient k optimal pour un signal M continu. Pour un signal M quelconque, la valeur trouvée par cette expression est multipliée par le rapport entre la valeur crête du signal M et sa valeur moyenne. En outre, le coefficient k optimal est fourni pour une impédance de ligne donnée. Généralement, l'impédance de ligne varie d'un emplacement à un autre et d'un pays à un autre. Ainsi, on utilisera l'impédance de ligne moyenne pour calculer le coefficient k.

La figure 4 représente un exemple de détecteur de saturation associé à un étage de sortie classique d'un amplificateur. Cet étage de sortie comprend un transistor PNP Q1 et un transistor NPN Q2 dont les collecteurs délivrent la tension $V_A$ appliquée au haut-parleur 18. L'émetteur du transistor Q1 reçoit la tension d'alimentation Vcc et l'émetteur du transistor Q2 est relié à la masse. Les bases des transistors Q1 et Q2 sont commandées de manière classique pour qu'un seul de ces deux transistors conduise à la fois. Le détecteur de saturation 26 comprend simplement un transistor PNP Q3 dont l'émetteur est relié au collecteur du transistor Q1 et dont la base est reliée à la base du transistor Q1.

Lorsque le transistor Q1 fonctionne en régime linéaire, sa tension base-émetteur est inférieure ou égale à sa tension collecteur-émetteur. Il en résulte que le transistor Q3 est bloqué puisque sa jonction base-émetteur est polarisée en inverse. Par contre, lorsque le transistor Q1 sature, sa tension collecteur-émetteur est nettement plus faible que sa tension base-émetteur. La jonction base-émetteur du transistor Q3 est alors polarisée dans le sens direct et son collecteur fournit le courant de détection Id.

Bien entendu, si le haut-parleur 18 est relié à la tension d'alimentation Vcc au lieu de la masse, c'est le transistor Q2 qui est muni d'un transistor de détection NPN symétrique au transistor Q3.

L'invention a été décrite dans le cadre d'un circuit de sonnerie téléphonique, mais il apparaîtra à l'homme du métier qu'elle peut s'appliquer à d'autres circuits d'adaptation d'impédance où il faut fournir une puissance aussi élevée que possible à une charge.

## Revendications

1. Dispositif adaptatif à l'impédance d'une ligne d'alimentation (L) pour alimenter une charge (18) de manière optimale, comprenant un régulateur de tension à découpage (12) sur lequel est prélevé un signal ($V_A$) fourni à la charge, et une boucle de régulation (20) pour régler l'amplitude du signal fourni à la charge en fonction de la tension ($V_L$) sur la ligne, caractérisé en ce qu'il comprend des moyens d'alignement de la tension de sortie (Vcc) du régulateur de tension sur l'amplitude du signal fourni à la charge.

2. Dispositif selon la revendication 1, caractérisé en ce que les moyens d'alignement comprennent :

   - un moyen de comparaison (26) fournissant un signal de détection actif (Id) lorsque la tension de sortie (Vcc) du régulateur de tension (12) est inférieure à l'amplitude réglée ($kM \cdot V_L$) du signal à fournir à la charge ; et
   - un filtre passe-bas (28) recevant le signal de détection et modifiant une tension de référence (Vref) du régulateur de tension.

3. Dispositif selon la revendication 2, caractérisé en ce que le régulateur de tension (12) reçoit une tension de référence basse ($V_0$) à laquelle est ajoutée la tension de sortie du filtre passe-bas (28).

4. Dispositif selon la revendication 2, caractérisé en ce qu'il comprend un amplificateur (16) alimentant la charge (18) et recevant le produit d'un signal de consigne (M) par la tension ($V_L$) sur la ligne, le moyen de comparaison étant formé d'un détecteur de saturation (26) de l'amplificateur.

5. Dispositif selon la revendication 4, caractérisé en ce que l'amplificateur comprend un transistor de sortie (Q1) alimentant la charge (18) à partir de la tension de sortie (Vcc) du régulateur de tension, le détecteur de saturation (Q3) étant prévu pour détecter la saturation du transistor de sortie.

**Patentansprüche**

1. Einrichtung zum Anpassen der Impedanz einer Versorgungsleitung (L), um eine Last (18) optimal zu versorgen, mit einem geschalteten Spannungsregler (12), von dem ein Signal ($V_A$) gezogen und an die Last angelegt wird, und einer Regelschleife (20) zum Einstellen der Amplitude des Signals, das an die Last angelegt wird, als eine Funktion der Leitungsspannung ($V_L$), **gekennzeichnet** durch Mittel zum Ausgleichen der Ausgangsspannung (Vcc) des Spannungsreglers mit der Amplitude des an die Last angelegten Signals.

2. Einrichtung nach Anspruch 1, dadurch **gekennzeichnet**, daß die Ausgleichmittel folgende Merkmale aufweisen:
   Vergleichermittel (26) zum Vorsehen eines Erfassungssignals ($I_d$), das aktiv ist, wenn die Ausgangsspannung (Vcc) des Spannungsreglers (12) niedriger ist als die eingestellte Amplitude ($kM·V_L$) des Signals, das an die Last angelegt wird, und ein Tiefpassfilter (28) zum Empfangen des Erfassungssignals und Modifizieren einer Bezugsspannung ($V_{ref}$) des Spannungsreglers.

3. Einrichtung nach Anspruch 2, dadurch **gekennzeichnet**, daß der Spannungsregler (12) eine niedrige Bezugsspannung ($V_0$) empfängt, zu der die Ausgangsspannung des Tiefpassfilters (28) addiert wird.

4. Einrichtung nach Anspruch 2, dadurch **gekennzeichnet**, daß sie einen Verstärker (16) zum Versorgung der Last (18) und Empfangen des Produkts aus einem Eingangssignal (M) und der Leitungsspannung ($V_L$) aufweist, wobei die Vergleichermittel durch einen Detektor (26) zum Erfassen der Sättigung des Verstärkers gebildet sind.

5. Einrichtung nach Anspruch 4, dadurch **gekennzeichnet**, daß der Verstärker einen Ausgangstransistor (Q1) aufweist, der die Last (18) ausgehend von der Ausgangsspannung (Vcc) des Spannungsreglers versorgt, wobei der Sättigungsdetektor (Q3) so gestaltet ist, daß er die Sättigung des Ausgangstransistors erfaßt.

**Claims**

1. A device for adapting to the impedance of a supply line (L) to optimally supply a load (18), including a switched mode voltage regulator (12) from which is drawn a signal ($V_A$) provided to the load, and a regulation loop (20) to adjust the amplitude of the signal provided to the load as a function of the line voltage ($V_L$), characterized in that it includes means for aligning the output voltage (Vcc) of the voltage regulator with the amplitude of the signal provided to the load.

2. The device of claim 1, characterized in that the aligning means include:

   - comparison means (26) for providing a detection signal (Id) which is active when the output voltage (Vcc) of the voltage regulator (12) is lower than an adjusted amplitude ($kM.V_L$) of the signal to be provided to the load, and
   - a low-pass filter (28) for receiving the detection signal and modifying a reference voltage (Vref) of the voltage regulator.

3. The device of claim 2, characterized in that the voltage regulator (12) receives a low reference voltage ($V_0$) to which the output voltage of the low-pass filter (28) is added.

4. The device of claim 2, characterized in that it includes an amplifier (16) for supplying the load (18) and receiving the product of an input signal (M) and of the line voltage ($V_L$), the comparison means being formed by a detector (26) for detecting the saturation of the amplifier.

5. The device of claim 4, characterized in that the amplifier includes an output transistor (Q1) supplying the load (18) from the output voltage (Vcc) of the voltage regulator, the saturation detector (Q3) being designed to detect the saturation of the output transistor.

Fig 1

Fig 2

Fig 3

Fig 4